# EUROPEAN PATENT SPECIFICATION

(11) **EP 1 320 875 B1**
(45) Date of publication and mention of the grant of the patent: **12.08.2015**
(21) Application number: 01970182.0
(22) Date of filing: 21.09.2001
(51) Int. Cl.: B08B 7/00, C09K 13/00, H01L 21/3065, H01L 21/311, H01L 21/3213, C23C 16/44

(54) **GAS COMPOSITIONS FOR CLEANING THE INTERIORS OF REACTORS AS WELL AS FOR ETCHING FILMS OF SILICON-CONTAINING COMPOUNDS**
GASZUSAMMENSETZUNGEN ZUR INNENREAKTORREINIGUNG UND ZUM ÄTZEN VON SILIZIUM ENTHALTENDEN VERBINDUNGEN
COMPOSITIONS DE GAZ SERVANT AU NETTOYAGE DE L'INTERIEUR DE REACTEURS DE MEME QUE POUR LA GRAVURE DE FILMS DE COMPOSES CONTENANT DU SILICIUM

(30) Priority: 25.09.2000 JP 2000290893
(43) Date of publication of application: 25.06.2003
(60) Divisional application: 11172271.6
(73) Proprietor: TOKYO ELECTRON LIMITED, Minato-ku, Tokyo 107-0052 (JP); Renesas Electronics Corporation, Kanagawa (JP); Panasonic Corporation, Kadoma-shi Osaka 571-8501 (JP); Daikin Industries, Ltd., Kita-ku Osaka-shi Osaka 530-8323 (JP); Canon Anelva Corporation, Kanagawa, Kawasaki-shi (JP); Sanyo Electric Co., Ltd., Osaka 570-8677 (JP); Hitachi Kokusai Electric Inc., Chiyoda-ku Tokyo 101-8980 (JP); Sony Corporation, Minato-ku Tokyo 108-0075 (JP); Kanto Denka Kogyo Co., Ltd., Chiyoda-ku Tokyo 101-0063 (JP); National Institute of Advanced Industrial Science and Technology, Tokyo 100-8921 (JP)
(72) Inventor: SEKIYA, Akira c/o NAT. INST. OF ADVANCED, Tsukuba-shi, Ibaraki 305-8565 (JP); FUKAE, Katsuya c/o SHIBUKAWA LABORATORY, Gunma 377-8513 (JP); MITSUI, Yuki c/o RESEARCH INSTITUTE OF INNOVATIVE, Minato-ku, Tokyo 105-0003 (JP); TOMIZAWA, Ginjiro, Tsukuba-shi, Ibaraki 305-0841 (JP)
(74) Representative: WP Thompson
(86) International application number: PCT/JP2001/008233
(87) International publication number: WO 2002/025713

(56) References cited:
- WO-A-99/67817
- JP-A- 4 026 116
- JP-A- 4 026 116
- JP-A- 5 291 203
- JP-A- 5 299 391
- JP-A- 6 025 859
- JP-A- 7 273 088
- JP-A- 2000 100 749
- US-A- 3 341 293
- US-A- 4 536 252
- US-A- 5 376 234
- W.B.FOX, C.A. WAMSER, R. EIBECK, D.K.HUGGINS, J.S. MACKENZIE AND R. JUURIK: "The chemistry of trifluoroamine oxide. II. Reactions with inorganic substrates", , vol. 8, no. 6, 26 September 1968 (1968-09-26), pages 1247-1249,

## Description

### Field of the Invention

This invention relates to gas compositions comprising fluorine-containing nitrogen compounds, which compositions are useful for cleaning the interior of reactors such as chambers for CVD (chemical vapor deposition) processes or etch proceses used for manufacturing semiconductor devices on substrates. The invention also relates to such gas compositions capable of efficiently etching films of silicon-containing compounds. Advantageously, the gas compositions have little or no tendency to generate an effluent gas stream containing noxious ingredients, such as CF₄, NF₃ and the like.

### Background of the Invention

To date, in processes for producing thin-film devices, such as for the production of semiconductors, thin films have been formed by known techniques such as CVD processes. In the formation of such a film, e.g. a thin film for semiconductor devices within a CVD chamber, though it is desirable to allow or permit a film-forming material to deposit preferentially over the target area or areas of the wafer substrate or substrates held in the CVD chamber, the film-forming material is also deposited, though wastefully, on the remaining surfaces exposed to the interior space of the CVD chamber, including, for example, the surfaces of inner walls of chamber, product-holding jigs, pipings, etc. Furthermore, during the deposition process, the material which has accumulated on surface areas other than' the target area(s) can be accidentally separated therefrom. Consequently, the peeled-off material or particles thereof can often be carried to the target area where a film is being formed or to be formed, and can cause the film to become contaminated therewith. This would prevent the process operation from producing films of satisfactory quality, and thus would lead to decreased yield. Therefore, it is necessary to remove any undesirably deposited material from the chamber at appropriate intervals and clean the chamber. Removal of the obstructive deposits from the interior of CVD chambers has been carried out manually or chemically, by means of cleaning gases.

In the production of semiconductors and other electronic devices, it is also necessary to partially remove a layer or layers of various semiconductive materials deposited on a wafer substrate by means of an etchant, typically an etching gas, so as to leave a semiconductor circuit in a pre-determined pattern on the wafer substrate.

Some fundamental properties are generally required for the chamber cleaning gas and the etching gas which both act to remove the materials deposited in the chamber. The cleaning gas should be able to rapidly clean the interior of the CVD chamber, while the etching gas should be able to selectively and rapidly etch the selected area or areas of deposited film. Further properties commonly required for the cleaning and etching gases include, for example, that they do not generate noxious effluent gases and they are environmentally friendly.

Heretofore, a class of perfluorocompounds, such as CF₄, C₂F₆, SF₆, NF₃ and the like have been employed in large amounts in the processes for producing semiconductors and other electronic devices, as a gas for either removing the deposited materials or for etching the deposited films.

However, these conventional perfluorocompound gases are stable substances that can last for a long period of time in the atmosphere and it is difficult to treat a waste gas stream omitting the cleaning step or the etching step in which the above-mentioned conventional cleaning or etching gases are employed. The waste gas stream may contain a high level of the cleaning or etching gas ingredient(s) in an undecomposed or undegraded state and the treatment to reduce these to acceptable levels before discharging to the atmosphere is very expensive. These aforementioned problems have been presented by the conventional cleaning and etching gases. Furthermore, it is known that the conventional perfluorocompound gases have very high global warming potential (ITH; 100 years): when compared with carbon dioxide (CO₂), CF₄ exhibits a factor 6,500 times; C₂F₆ exhibits a factor 9,200 times; SF₆ exhibits a factor 23,900 times; and NF₃ exhibits a factor 8,000 times, respectively, that of CO₂. There is a concern that these substances could have a serious effect on the environment.

Under the circumstances, there has been a strong need for a substitute etching or cleaning gas that has a low global warming potential, one which exhibits excellent performance in cleaning deposits of silicon-containing compounds as well as excellent etching performance for the silicon-containing compound films.

Even if a gas itself as used in the cleaning or etching process has no or little effect on the environment, the gas could be subject to decomposition during the cleaning or etching process, at the same time generating noxious gases, such as CF₄ and NF₃, which last for a long period of time in the atmosphere. Therefore, it is desired to provide a substitute etching or cleaning gas that will not decompose to produce any noxious gas or gases having an adverse effect on the environment.

Thus, the inventors, having focused their efforts on research into the amelioration or elimination of the above-mentioned prior art problems, have now discovered that a particular kind of fluorine-containing nitrogen compound offers:
improved ability to clean deposits comprising silicon-containing compound(s), while generating, during use in a cleaning process, an effluent gas stream containing no noxious compounds, such as CF₄, NF₃ or the like, that seriously contribute to global warming; also,
improved ability to etch a thin film comprising silicon-containing compound(s), while generating, during use in an etching process, an effluent gas stream containing no noxious compounds, such as CF₄, NF₃ or the like, that seriously contribute to global warming.

The present invention has been developed and accomplished on the basis of the above finding.

Accordingly, an object of the invention is to provide a CVD chamber cleaning gas composition which has excellent performance in cleaning deposits comprising silicon-containing compound(s) and, thus, is useful for cleaning the interior of reactors such as chambers for CVD process used for manufacturing semiconductors, and other electronic devices or the like layered on wafer substrates, and which will generate, during use in a cleaning process, an effluent gas stream containing no noxious compounds, such as CF₄, NF₃ and the like, that seriously contribute to global warming.

A further object of the invention is to provide an etching gas composition which offers excellent performance in etching films comprising silicon-containing compound(s) for manufacturing semiconductors, and other electronic devices or the like layered on substrates, and which will generate, during use in an etching process, an effluent gas stream containing no noxious compounds, such as CF₄ or the like, that seriously contribute to global warming.

WO 99/67817 discloses silicon trench etching using silicon-containing precursors to reduce or avoid mask erosion. US 3, 341, 293 discloses the preparation of fluoro compounds.

### Summary of the Invention

### CVD Chamber Cleaning Gas Compositions:

In accordance with a first aspect of the invention, there is provided:
a gas composition consisting of F₃NO, O₂ and one or more inert gases, the content of said F₃NO being in the range of 5-70 mol% per 100 mol% of the total content of the gas ingredients in said composition; or
a gas composition consisting of F₃NO and O₂, the content of said F₃NO being in the range of 5-70 mol% per 100 mol% of the total content of the gas ingredients in said composition; or
a gas composition consisting of F₃NO and one or more inert gases, the content of said F₃NO being in the range of 5-70 mol% per 100 mol% of the total content of the gas ingredients in said composition.

In accordance with a second aspect of the invention, there is provided the use of the above-mentioned gas composition for cleaning the interior of CVD chambers.

Suitable examples of inert gases which may be used in the above-mentioned CVD chamber cleaning gas composition include N₂, He, Ne, Ar, Kr, Xe and Rn.

The F₃NO-containing gas compositions for cleaning reactors are, in particular, suitable for use in cleaning the interior of the chambers of CVD equipment. The gas compositions are generally suitable for removing depositions comprising a silicon-containing compound or compounds. Typical examples of the silicon-containing compounds include (1) compounds consisting essentially of silicon; (2) compounds consisting essentially of silicon and at least one of oxygen, nitrogen, fluorine and carbon; and (3) compounds comprising high melting point metal silicides.

### Etching Gas Compositions:

Further according to a third aspect of the invention, there is provided the use of the above-mentioned gas composition for etching films of silicon-containing compounds.

Suitable examples of the inert gases which may be used in the above-mentioned etching gas compositions include N₂, He, Ne, Ar, Kr, Xe and Rn.

Typical examples of the silicon-containing compounds which may be etched by the above etching gas compositions include: (1) compounds consisting essentially of silicon; (2) compounds consisting essentially of silicon and at least one of oxygen, nitrogen, fluorine and carbon; and (3) compounds comprising high melting point metal silicides. Embodiments of the Invention

The gas compositions for removing deposits comprising silicon-containing compounds in CVD chambers and for etching film layers comprising silicon-containing compounds in accordance with the invention comprise specific fluorine-containing nitrogen compounds, or combinations thereof with other gas ingredients. These will be described in more detail.

### CVD CHAMBER CLEANING GAS COMPOSITIONS:

The CVD chamber cleaning gas compositions according to the invention consist of F₃NO (nitrosyl trifluoride) and O₂ and/or inert gases. According to claim 1.

### F₃NO-containing compositions (the first cleaning gas compositions)

The first chamber cleaning gas compositions of the invention are characterized by inclusion of F₃NO and O₂ and/or one or more inert gases. The content of F₃NO employed in the first chamber cleaning gas compositions ranges from 5 to 70 mol %, preferably from 15 to 60 mol % per 100 mol % of the total quantity of the gas ingredients in the compositions.

In the case where the first chamber cleaning gas compositions consist of F₃NO and O₂, the content of F₃NO desirably ranges from 5 to 40 mol %, preferably from 10 to 30 mol %, per 100 mol % of the total quantity of the gas ingredients in the compositions. The content of O₂ desirably ranges from 60 to 95 mol %, preferably from 70 to 90 mol %.

In the case where the first chamber cleaning gas compositions consist of F₃NO and one or more inert gases, the content of F₃NO desirably ranges from 10 to 70 mol %, preferably from 20 to 60 mol %, per 100 mol % of the total quantity of the gas ingredients in the compositions. The content of said inert gas or gases desirably ranges from 30 to 90 mol %, preferably from 40 to 80 mol %.

Further, in the case where the first chamber cleaning gas compositions consist of F₃NO, O₂ and one or more inert gases, the content of F₃NO ranges from 5 to 70 mol %, preferably from 15 to 60 mol %, per 100 mol % of the total quantity of the gas ingredients in the compositions. The content of O₂ desirably ranges from 25 to 80 mol %, preferably from 30 to 70 mol %. The content of said inert gas or gases desirably ranges from 5 to 50 mol %, preferably from 5 to 30 mol %.

Where the F₃NO content used in the first chamber cleaning gas compositions falls within the above-mentioned ranges, it is possible to quickly remove the deposits on the surfaces of the interior of the CVD cambers. Where the cleaning gas compositions include O₂ and/or inert gas(es) in the above-mentioned ranges, then the cleaning performance of the compositions are enhanced and improved.

In view of the chemical structure and physical and chemical properties of F₃NO used in the chamber cleaning gas compositions of the invention, it is believed that the compound would have a short lifetime in the atmosphere and would have less impact on global warming. Therefore, only a very slight adverse effect on environment would be caused even if the chamber cleaning gas compositions were discharged into the atmosphere.

Further, even when F₃NO is decomposed or degraded during or after use in the cleaning process, it would emit little or no noxious gases, such as CF₄, NF₃ and the like, that have high global warming potential and have adverse environmental effects.

Furthermore, since F₃NO has a low boiling point of -87.6°C, it is present in the gas phase when it is used under the conditions employed in the production of semiconductors and other electronic devices. The gaseous F₃NO or gaseous mixtures containing it may be handled easily in the chamber cleaning operation.

F₃NO may be prepared, for example, by the below-formulated two-stage route, but the preparation is not limited to this route:

NF₃ + N₂O + 2SbF₅ → NF₂O⁺Sb₂F₁₁⁻ + N₂

NF₂O+Sb₂F₁₁⁻ + 2NaF → F₃NO + 2NaSbF₆

The inert gases which may be used in the invention include, for example, N₂, He, Ne, Ar, Kr, Xe, and Rn.

As used herein, the expression "to clean a chamber" or any other synonymous expression is intended to mean removal of the films deposited on the surfaces of the inner walls, jigs, pipings, etc. exposed to the inside of chamber for manufacturing semiconductors or other electronics devices.

The above-mentioned gas compositions comprising the specific fluorine-containing nitrogen compounds, oxygen and other gases according to the invention may be used advantageously for cleaning CVD chambers, for example CVD equipment.

The target substances that are removed from the chamber by the fluorine-containing nitrogen compounds according to the invention may be any deposit comprising the aforementioned silicon-containing compounds that have accumulated on the surfaces of the inner walls of the CVD chamber, jigs, pipings and other parts in the CVD apparatus during operation of the CVD process. Typical examples of the silicon-containing compounds include:
(1) compounds consisting essentially of silicon,
(2) compounds consisting essentially of silicon and at least one of oxygen, nitrogen, fluorine and carbon, and
(3) compounds comprising high melting point metal silicides. Particular examples that may be mentioned include Si, SiO₂, Si₃N₄ and high melting point metal silicides, such as WSi, and the like.

The material from which the CVD chambers to be cleaned by the chamber cleaning gas compositions of the present invention are prepared is not critical, and may be, for example, stainless steel, aluminum or alloys thereof.

The chamber cleaning gas compositions of the present invention can quickly remove the deposits on the surfaces of the inner walls of the CVD chamber, jigs, pipings or other parts in the CVD apparatus, while having no or little adverse effects, such as corrosion, erosion and petting, on these chamber materials.

Removal of the deposits comprising silicon-containing compounds and possibly traces of other substances present in the interior of the CVD chamber using the cleaning gas composition comprised of fluorine-containing nitrogen compounds of the invention may be conducted in any known convenient manner. Various dry cleaning techniques, for example, plasma cleaning, remote plasma cleaning and microwave cleaning techniques may be employed. Thus, by means of the chamber cleaning gas compositions according to the invention, the deposited silicon-containing compounds may be efficiently removed.

### GAS COMPOSITIONS FOR ETCHING FILM OF SILICON-CONTAINING COMPOUNDS:

The gas compositions for etching a thin film of silicon-containing compounds of the invention contain F₃NO and other gas ingredient (s) in accordance with claim 1.

### F₃NO-containing compositions (the first etching gas compositions)

As mentioned hereinbefore, the first gas composition for etching a thin film of silicon-containing compounds according to the invention is characterized by inclusion of F₃NO and O₂ and/or one or more inert gases. The concentrations of F₃NO, O₂ and inert gases in the first etching gas composition are in accordance with claim 1.

The first etching gas compositions containing the ingredients in the specified proportions can rapidly etch a thin film of silicon-containing compounds.

In view of its chemical structure and chemical and physical properties, the primary ingredient F₃NO employed in the first etching gas compositions is believed to have a short lifetime in the atmosphere and would contribute less to global warming. Therefore, only a very slight adverse effect on environment would be caused, even if the etching gas compositions were discharged into the atmosphere.

Further, even when F₃NO decomposes during use of the first etching gas composition in the etching process, it would emit little or no noxious gases, such as CF₄, NF₃ and the like, that have high global warming potential and adverse environmental effects.

Furthermore, because the first etching gas compositions can highly selectively attack the films to be processed or etched, it is feasible for them to be employed as substitutes for the conventional etchant gases, such as CF₄, NF₃, etc.

As inert gases that may be incorporated into the first etching gas compositions according to the invention, N₂, He, Ne, Ar, Kr, Xe and Rn may be mentioned.

### The materials to be etched:

The materials to be etched with the etching gas compositions of the invention include a thin film comprising silicon-containing compounds. Typical examples which may be mentioned are at least one of:
(1) compounds consisting essentially of silicon,
(2) compounds consisting essentially of silicon and at least one of oxygen, nitrogen, fluorine and carbon, and
(3) compounds comprising high melting point metal silicides.

Particular examples that may be mentioned include Si film, SiO₂ film, Si₃N₄ film and films of high melting point metal silicides, such as WSi, and the like.

Etching of the films comprising silicon-containing compounds by means of the etching gas compositions comprising fluorine-containing nitrogen compounds of the invention may be conducted in any known convenient manner. Various dry etching techniques, for example, plasma etching, reactive ion etching and microwave etching techniques may be employed. The conditions under which the present etching gas compositions are employed for etching may be similar to those suitable for application of the known etching techniques.

### Advantages achieved by the Invention:

The chamber cleaning gas compositions of the invention show little or no tendency towards generation, during or after use in a cleaning step, of an effluent gas stream containing noxious compounds, such as CF₄, NF₃ or the like, that could have an effect on global warming. Use of the chamber cleaning gas compositions of the present invention has only a limited effect on the environment. The chamber cleaning gas compositions of the invention may be handled with ease, can quickly remove the films adhering to the interior of the CVD chamber, and have improved cleaning qualities compared to those of conventional cleaning gases.

Furthermore, the present gas compositions for etching silicon-containing films show little or no tendency towards generation, during use in an etching process, of an effluent gas stream containing noxious compounds, such as CF₄, NF₃ or the like, that would have an effect on global warming. Use of the etching gas compositions of the present invention has only a limited effect on the environment. The etching gas compositions according to the invention can efficiently etch silicon-containing films while ensuring high dimensional accuracy of the product semiconductor patterns; they also demonstrate excellent etching capabilities compared to those of conventional etchant gases.

### EXAMPLE

The invention will be further illustrated in detail with reference to the following Examples which are not intended to be restrictive in any way to the scope of the invention.

### PREPARATION 1 : SYNTHESIS OF F₃NO

A dried 200 ml "HASTELLOY"* reactor vessel was charged with 26 g (0.12 mol) of antimony pentafluoride(SbF₅) followed by 14.2 g (0.2 mol) of nitrogen trifluoride(NF₃) and 8.8 g (0.2 mol) of nitrous oxide (N₂O). The mixture was allowed to react at 150°C for a period of 60 hours. The resulting product NF₂O+Sb₂F₁₁⁻ was treated with 10 g (0.24 mol) of sodium fluoride (NaF) and, then the mixture was allowed to react at -210°C for a period of 20 hours. The reaction product was subjected to isolation and purification to yield 3.5 g (0.04 mol) of F₃NO. The resulting product was analyzed by gas chromatography and FT-IR and identified to be F₃NO thereby. The yield was 20% on the basis of the starting nitrogen trifluoride. (* a trade name of an alloy commercially available from Hayness Satellite Co.)

### EXAMPLES 1 - 7

### Chamber cleaning test:

Samples of F₃NO as produced in the above PREPARATION 1 were mixed with oxygen or argon (Ar) in various proportions as shown in TABLE 1.

A sample of silicon wafer having an SiO₂ film deposited over the surface thereof was placed in a CVD chamber and subjected to a cleaning test using one of the gas mixtures shown in TABLE 1, under the following cleaning conditions: a pressure of 110 Pa; an input Rf power of 290 W; and a total gas flow rate of 60 sccm. The cleaning procedure under these conditions was performed for a period of 2 minutes. The results of cleaning performance for each of the test cleaning gas compositions are shown in TABLE 1 below.

**TABLE 1**

| Examples | | 1 | 2 | 3 | 4 | 5 | 6 | 7 |
|---|---|---|---|---|---|---|---|---|
| Cleaning Gas Composition mol % | F₃NO | 10 | 15 | 20 | 40 | 20 | 40 | 60 |
| | O₂ | 90 | 85 | 80 | 60 | - | - | - |
| | Ar | - | - | - | - | 80 | 60 | 40 |
| Total mol % | | 100 | 100 | 100 | 100 | 100 | 100 | 100 |
| Cleaning rate Å/min. | | 480 | 650 | 630 | 440 | 460 | 560 | 540 |

### COMPARATIVE EXAMPLES 1 - 3

### Chamber cleaning test with conventional cleaning gas compositions:

The cleaning test procedure in the previous EXAMPLES was substantially repeated using some conventional cleaning gas compositions as shown in TABLE 3. The results are set forth in TABLE 3.

**TABLE 3**

| Comparative Examples | | 1 | 2 | 3 |
|---|---|---|---|---|
| Cleaning gas composition, mol % | C₂F₆ | 30 | 40 | 50 |
| | O₂ | 70 | 60 | 50 |
| Total | mol % | 100 | 100 | 100 |
| Cleaning rate Å/min. | | 670 | 690 | 680 |

From the cleaning test results of the above Examples, the feasibility of the present etching gas compositions is proved beyond doubt.

## Claims

1. A gas composition consisting of F₃NO and O₂ and/or one or more inert gases, the content of said F₃NO being in the range of 5 - 70 mol% per 100 mol% of the total content of the gas ingredients in said composition.

2. A gas composition as claimed in claim 1, in which said inert gas or gases are selected from the group consisting of N₂, He, Ne, Ar, Kr, Xe and Rn.

3. Use of a gas composition as claimed in claim 1 or claim 2, for cleaning the interior of CVD chambers.

4. Use as claimed in claim 3, for removing a deposit consisting of a silicon-containing compound or compounds in the interior of said chambers.

5. Use of a gas composition as claimed in claim 1 or claim 2, for etching a thin film comprising a silicon-containing compound or compounds.

6. Use as claimed in claim 4 or claim 5, in which said silicon-containing compound or compounds are at least one selected from the group consisting of:
(1) compounds consisting essentially of silicon,
(2) compounds consisting essentially of silicon and at least one of oxygen, nitrogen, fluorine and carbon, and
(3) compounds comprising high melting point metal silicides.

## Patentansprüche

1. Gaszusammensetzung, die aus F₃NO und O₂ und/oder einem oder mehreren Inertgasen besteht, wobei der Gehalt des genannten F₃NO im Bereich von 5-70 mol% pro 100 mol% des gesamten Gehalts der Gasbestandteile in der genannten Zusammensetzung liegt.

2. Gaszusammensetzung nach Anspruch 1, in der das genannte Inertgas oder die genannten Inertgase aus der Gruppe ausgewählt sind, die aus Folgenden besteht: N₂, He, Ne, Ar, Kr, Xe und Rn.

3. Verwendung einer Gaszusammensetzung nach Anspruch 1 oder Anspruch 2 für das Reinigen des Inneren von CVD-Kammern.

4. Verwendung nach Anspruch 3 für die Entfernung einer Ablagerung, die aus einer siliciumhaltigen Verbindung oder Verbindungen besteht, im Inneren der genannten Kammern.

5. Verwendung einer Gaszusammensetzung nach Anspruch 1 oder Anspruch 2 für das Ätzen eines dünnen Films, der eine siliciumhaltige Verbindung oder Verbindungen umfasst.

6. Verwendung nach Anspruch 4 oder Anspruch 5, in der die genannte siliciumhaltige Verbindung oder die genannten siliciumhaltigen Verbindungen mindestens eine ausgewählte aus der Gruppe ist/sind, die aus Folgenden besteht:
(1) Verbindungen, die im Wesentlichen aus Silicium bestehen,
(2) Verbindungen, die im Wesentlichen aus Silicium und mindestens einem von Sauerstoff, Stickstoff, Fluor und Kohlenstoff bestehen, und
(3) Verbindungen, die hochschmelzende Metallsilizide umfassen.

## Revendications

1. Composition gazeuse consistant en du F₃NO et de l'O₂ et/ou un ou plusieurs gaz inertes, la teneur en F₃NO étant dans la plage de 5 - 70 % en moles par 100 % en moles de la teneur totale en ingrédients gazeux dans ladite composition.

2. Composition gazeuse selon la revendication 1, dans laquelle le(s)dit(s) gaz inerte(s) est(sont) sélectionné(s) dans le groupe consistant en N₂, He, Ne, Ar, Kr, Xe et Rn.

3. Utilisation d'une composition gazeuse selon la revendication 1 ou la revendication 2 pour nettoyer l'intérieur d'une enceinte de dépôt chimique en phase vapeur.

4. Utilisation selon la revendication 3 pour enlever un dépôt consistant en un ou des composés contenant une silicone à l'intérieur desdites enceintes.

5. Utilisation d'une composition gazeuse selon la revendication 1 ou la revendication 2 pour graver une fine pellicule comprenant un ou des composés contenant une silicone.

6. Utilisation selon la revendication 4 ou la revendication 5, dans laquelle le(s)dit(s) composé(s) contenant une silicone est(sont) un au moins de ceux du groupe consistant en les suivants :
(1) composés consistant essentiellement en une silicone,
(2) composés consistant essentiellement en une silicone et en un au moins des suivants : oxygène, azote, fluor et carbone et
(3) composés comprenant des silicides métalliques à point de fusion élevé.
